# FASCICULE DE BREVET EUROPEEN

(11) **EP 4 519 701 B1**
(45) Date de publication et mention de la délivrance du brevet: **10.12.2025**
(21) Numéro de dépôt: 22748058.9
(22) Date de dépôt: 02.05.2022
(51) Int. Cl.: G01R 31/26

(54) **DISPOSITIF ET PROCÉDÉ DE CARACTÉRISATION DE L'EFFONDREMENT DE COURANT DE TRANSISTORS GAN**
VORRICHTUNG UND VERFAHREN ZUR CHARAKTERISIERUNG DES STROMKOLLAPS VON GAN-TRANSISTOREN
DEVICE AND METHOD FOR CHARACTERIZING THE CURRENT COLLAPSE OF GAN TRANSISTORS

(43) Date de publication de la demande: 12.03.2025
(73) Titulaire: Commissariat à l'Energie Atomique et aux Energies Alternatives, 75015 Paris (FR)
(72) Inventeur: NGUYEN, Van-Sang, 38054 GRENOBLE CEDEX 09 (FR); BIER, Anthony, 38054 GRENOBLE CEDEX 09 (FR); CATELLANI, Stéphane, 38054 GRENOBLE CEDEX 09 (FR)
(74) Mandataire: Santarelli
(86) Numéro de dépôt international: PCT/FR2022/050841
(87) Numéro de publication internationale: WO 2023/214122

(56) Documents cités:
- KUMAR RUSTAM ET AL: "H-Bridge Derived Topology for Dynamic On-Resistance Evaluation in Power GaN HEMTs", IEEE TRANSACTIONS ON INDUSTRIAL ELECTRONICS, IEEE SERVICE CENTER, PISCATAWAY, NJ, USA, vol. 70, no. 2, 1 April 2022 (2022-04-01), pages 1532 - 1541, XP011922437, ISSN: 0278-0046, [retrieved on 20220404], DOI: 10.1109/TIE.2022.3161822
- YANG FEI ET AL: "Experimental Evaluation and Analysis of Switching Transient's Effect on Dynamic on-Resistance in GaN HEMTs", IEEE TRANSACTIONS ON POWER ELECTRONICS, INSTITUTE OF ELECTRICAL AND ELECTRONICS ENGINEERS, USA, vol. 34, no. 10, 1 October 2019 (2019-10-01), pages 10121 - 10135, XP011733491, ISSN: 0885-8993, [retrieved on 20190701], DOI: 10.1109/TPEL.2019.2890874
- LI RUI ET AL: "Dynamic on-State Resistance Test and Evaluation of GaN Power Devices Under Hard- and Soft-Switching Conditions by Double and Multiple Pulses", IEEE TRANSACTIONS ON POWER ELECTRONICS, INSTITUTE OF ELECTRICAL AND ELECTRONICS ENGINEERS, USA, vol. 34, no. 2, 1 February 2019 (2019-02-01), pages 1044 - 1053, XP011701590, ISSN: 0885-8993, [retrieved on 20181218], DOI: 10.1109/TPEL.2018.2844302
- JONES EDWARD A ET AL: "Hard-Switching Dynamic Rds,on Characterization of a GaN FET with an Active GaN-Based Clamping Circuit", 2019 IEEE APPLIED POWER ELECTRONICS CONFERENCE AND EXPOSITION (APEC), IEEE, 17 March 2019 (2019-03-17), pages 2757 - 2763, XP033555164, DOI: 10.1109/APEC.2019.8722177

## Description

### DOMAINE TECHNIQUE

La présente demande se rapporte au domaine des transistors à base de GaN et concerne en particulier un dispositif de mesure amélioré permettant d'évaluer la résistance dynamique à l'état passant de tels transistors.

### ÉTAT DE LA TECHNIQUE ANTÉRIEURE

Les transistors à base de GaN ont notamment pour avantage de supporter de grandes densités de courant ainsi que de très hautes fréquences de découpage. Ils trouvent des applications dans le domaine des circuits de puissance tels que les convertisseurs d'énergie électrique et les onduleurs.

Cependant ces transistors sont l'objet d'un phénomène d'effondrement du courant (« current collapse » selon la terminologie anglo-saxonne) dû à des pièges d'électrons dans leur structure semi-conductrice. Un tel phénomène est évoqué par exemple dans le document de T. Hasan, "Mechanism and Suppression of Current Collapse in AlGaN/GaN High Electron Mobility Transistors", PhD thesis - University of Fukui, Japan, 2013.

L'origine de tels pièges peut être une conséquence de plusieurs facteurs, comme par exemple des défauts cristallins, des dislocations, ou la présence d'impuretés. De tels pièges peuvent être également trouvés dans l'interface entre différents matériaux semi-conducteurs et des couches de passivation. Dans les transistors à base de GaN, les pièges sont principalement localisés dans le GaN ou dans l'interface entre cette couche et une autre couche de matériau à grand Gap par exemple à base d'AlGaN.

Le phénomène d'effondrement du courant impacte significativement les circuits en particulier les circuits de puissance tels que les convertisseurs ou les onduleurs, qui plus est lorsqu'un fonctionnement à haute température et à faible tension de fonctionnement est requis. Ceci peut même occasionner une casse thermique des composants.

Le document: "The effect of dynamic On-state resistance to systems losses in GaN-based hard switching applications", de R. Hou, J. Lu, PCIM 2019, et le document :"The impact of GaN HEMT dynamic On-state resistance on converter performance", de Cai et al., IEEE Applied Power Electronics Conference and Exposition, Tampa, FL, Mar. 2017, présentent différentes méthodes d'évaluation de la résistance dynamique drain source d'un transistor GaN. Une autre méthode est présentée dans "H-Bridge Derived Topology for Dynamic On-Resistance Evaluation in Power GaN HEMTs", Kumar Rustam et al, IEEE Transactions on Industrial Electronics, IEEE SERVICE CENTER, PISCATAWAY, NJ, USA, vol. 70, no. 2, 1 avril 2022, pages 1532-1541.

Il se pose le problème de trouver un dispositif permettant de réaliser une mesure de de la résistance dynamique drain - source d'un transistor GaN ayant une précision améliorée et qui soit aisément adaptable au test en série de tels composants.

### EXPOSÉ DE L'INVENTION

Selon un mode de réalisation, la présente invention concerne un dispositif d'évaluation dispositif d'évaluation de la résistance dynamique à l'état passant d'un transistor à base de GaN, comprenant un circuit de test ayant :
- un premier bras de circuit, ledit premier bras étant doté d'un premier élément interrupteur et d'un deuxième élément interrupteur connectés entre eux à un premier nœud, ledit circuit de test étant doté d'un troisième élément interrupteur connecté à deuxième nœud, ledit troisième élément interrupteur étant apte à former un deuxième bras dudit circuit de test avec ledit transistor à base de GaN lorsque ledit transistor à base de GaN est connecté au deuxième nœud,
- une alimentation délivrant une tension d'alimentation au premier bras et au deuxième bras,
- une branche entre le premier nœud et le deuxième nœud munie d'une charge inductive et d'un capteur de courant, pour mesurer un courant traversant cette charge inductive,
- un interrupteur de mesure pour alternativement connecter ledit transistor à base de GaN à un étage de mesure de tension drain-source à l'état passant dudit transistor base de GaN, et déconnecter ledit transistor à base de GaN dudit étage de mesure de tension drain-source lorsque ledit interrupteur de mesure est mis à l'état bloqué,
- un étage de commande desdits premier, deuxième et troisième éléments interrupteurs, dudit transistor à base de GaN et de l'interrupteur de mesure, l'étage de commande étant configuré pour :
- selon une phase dite « de mesure », mettre, une ou plusieurs fois alternativement le circuit de test dans une première configuration, puis dans une deuxième configuration, la première configuration étant une configuration dans laquelle le premier élément interrupteur et ledit transistor à base de GaN sont rendus passants tandis que le deuxième élément interrupteur et le troisième élément interrupteur sont rendus bloqués, de sorte mettre en série ladite alimentation, ladite branche, et le ledit transistor à base de GaN, la deuxième configuration étant une configuration durant laquelle le deuxième élément interrupteur et le troisième élément interrupteur sont à l'état passant tandis que le premier élément interrupteur et ledit transistor à base de GaN sont mis à l'état bloqué de sorte à mettre en circuit fermé ladite branche avec ladite alimentation,
l'étage de commande étant configuré pour déclencher une connexion de l'étage de mesure de tension drain-source audit transistor base de GaN après que le circuit de test soit mis dans la première configuration, et pour déclencher une déconnexion de l'étage de mesure de tension drain-source dudit transistor base de GaN préalablement à ce que le circuit de test soit mis dans la deuxième configuration.

Par rapport aux dispositifs de test de type impulsionnel, le circuit de test du dispositif suivant l'invention permet une caractérisation plus proche des comportements de transistor GaN dans leur domaine applicatif.

Selon un mode avantageux, l'étage de commande est en outre configuré pour, préalablement à la phase de mesure, mettre en œuvre une phase de trempage d'une durée prédéterminée réglable, en rendant passants le premier interrupteur et le troisième interrupteur tandis que le deuxième interrupteur et le transistor à base de GaN sont maintenus bloqués de sorte à mettre le premier nœud et le deuxième nœud à ladite tension d'alimentation.

Selon une possibilité de mise en œuvre, l'étage de commande est configuré pour déclencher une connexion de l'étage de mesure de tension drain-source audit transistor base de GaN, un premier délai réglable prédéterminé après que le circuit de test soit mis dans la première configuration, et pour déclencher une déconnexion de l'étage de mesure de tension drain-source dudit transistor base de GaN, un deuxième délai réglable prédéterminé avant que le circuit de test soit mis dans la deuxième configuration.

Selon une possibilité de réalisation, l'étage de mesure de la tension drain-source comprend un amplificateur opérationnel monté en suiveur et dont l'entrée non-inverseuse est apte à être connectée à l'électrode de drain du transistor à base de GaN.

Avantageusement, l'étage de commande est configuré pour déclencher un passage de la première configuration vers la deuxième configuration ou de la deuxième configuration vers la première configuration en fonction des variations d'un signal en provenance d'un circuit de régulation du courant de ladite charge inductive, ce signal résultant lui-même d'une comparaison entre ledit courant traversant la charge inductive et une valeur de consigne.

Selon une possibilité de mise en œuvre, le circuit de régulation est configuré pour établir la différence entre une valeur moyennée du courant traversant la charge inductive et ladite consigne, et comporte un étage correcteur, en particulier de type proportionnel intégral, configuré pour calculer un rapport cyclique à partir de cette différence, ce rapport cyclique, compris entre zéro et un, étant représentatif d'une proportion entre la durée de ladite première configuration et la durée totale de la première configuration et de la deuxième configuration successives, la valeur du rapport cyclique étant transmise par le biais dudit signal en provenance d'un circuit de régulation à un circuit de modulation par largeur d'impulsion de l'étage de commande pour piloter la grille du premier élément interrupteur, du deuxième élément interrupteur, du troisième élément interrupteur, et dudit transistor à base de GaN.

Selon une possibilité de mise en œuvre le dispositif peut comprendre en outre un moyen de chauffage du transistor à base de GaN. Ce moyen de chauffage peut être en particulier doté d'une source de rayonnement infrarouge configurée pour émettre un faisceau lumineux infrarouge localisé sur le transistor à base de GaN.

Le transistor à base de GaN est typiquement amené à être connecté de manière provisoire sur le circuit de test.

Ainsi, selon une possibilité, ledit circuit est agencé sur un support doté de zones ou structures de connexion sur lesquelles, respectivement une électrode de source, une électrode de drain, et une électrode de grille du transistor GaN sont aptes à être connectées de manière amovible.

Avantageusement, le transistor à base de GaN est encapsulé et/ou monté sur boitier et ledit circuit de test est agencé sur un support, les structures de connexion étant des structures de connexion et d'accueil prévues respectivement pour permettre un assemblage solidaire du transistor sur ledit support.

Selon une autre possibilité, le transistor est agencé sur une plaque (« wafer » selon la terminologie anglo-saxonne) comportant une pluralité de puces électroniques, chaque puce électronique étant dotée d'au moins un autre transistor GaN, le transistor GaN étant connecté audit support du circuit de test.

Selon un autre aspect, la présente demande concerne un procédé microélectronique comprenant au moins une étape d'évaluation de résistance dynamique à l'état passant d'un transistor GaN à l'aide d'un dispositif tel que défini précédemment, le procédé comprenant des étapes consistant à :
- connecter le transistor à base de GaN aux zones de connexion afin d'évaluer sa résistance dynamique drain source à l'état passant, puis
- déconnecter, le transistor desdites zones de connexion, puis,
- découper le support afin de séparer lesdites puces électroniques.

### BRÈVE DESCRIPTION DES DESSINS

La présente invention sera mieux comprise sur la base de la description qui va suivre et des dessins en annexe sur lesquels :
La figure 1 sert à illustrer un exemple de structure de transistor à base de GaN dont la résistance dynamique drain source à l'état passant peut être évaluée par le biais d'un dispositif mis en œuvre suivant l'invention ;
La figure 2 sert à illustrer un dispositif pour évaluer la résistance dynamique drain source à l'état passant d'un transistor à base de GaN dans lequel le transistor est agencé en tant qu'élément interrupteur d'un circuit de test à plusieurs interrupteurs et dont l'agencement s'apparente à celui d'un montage de type onduleur ;
La figure 3 donne un exemple de chronogramme de fonctionnement du dispositif de la figure 2 ;
La figure 4 sert à illustrer un exemple de dispositif de chauffage à faisceau infra-rouge pour chauffer de manière localisée le transistor GaN lorsqu'une mesure de résistance dynamique à l'état passant de ce dernier est effectuée ;
La figure 5A sert à illustrer un exemple d'agencement des zones de connexion dans le circuit de test et auxquelles le transistor à base de GaN peut être connecté de manière provisoire et amovible le temps d'une évaluation de résistance dynamique à l'état passant de ce transistor ;
La figure 5B sert à illustrer un exemple d'agencement des structures de connexion et d'accueil du circuit de test auxquelles le transistor à base de GaN peut être connecté de manière provisoire et amovible le temps d'une évaluation de résistance dynamique à l'état passant de ce transistor ;
La figure 6 sert à illustrer une mesure effectuée lorsque le transistor à base de GaN est encore agencé sur la plaque (wafer) sur laquelle il vient d'être fabriqué.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

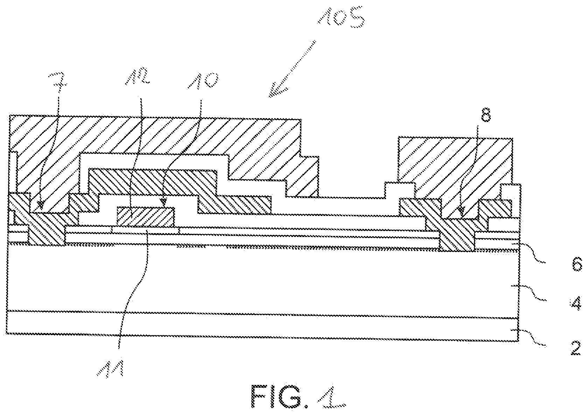

La figure 1 donne à présent une vue schématique en coupe d'un exemple de structure de transistor à base de GaN 105 dont on souhaite évaluer la résistance dynamique drain-source à l'état passant R_{DS_ON_dyn}.

Le transistor 105 est réalisé à partir d'un substrat semi-conducteur 2, par exemple à base de silicium, sur lequel un bloc semi-conducteur comprenant une hétérojonction est disposé. L'hétérojonction est réalisée dans un empilement comprenant une première couche 4 d'un matériau semi-conducteur III-N ayant une première bande interdite et une deuxième couche 6 d'un matériau semi-conducteur III-N ayant une deuxième bande interdite, plus grande que ladite première bande interdite. Pour un transistor dit « en GaN » ou « à base de GaN », la première couche 4 est typiquement à base de GaN tandis que la deuxième couche 6 peut être, par exemple, en AlGaN.

Le transistor comprend en outre des contacts électriques de source 7 et de drain 8, qui sont disposés sur et en contact avec des régions de la deuxième couche 6. Chacun des contacts électriques 7 et 8 peut être une couche métallique ou un empilement de couches métalliques. Un gaz d'électrons bidimensionnel 2-DEG peut être formé dans une région de canal située dans la première couche 4, typiquement sous l'interface entre la deuxième couche 6 et la première couche 4.

Le transistor comprend en outre une électrode de grille 10 qui peut être disposée en contact et ici sur une partie de la deuxième couche 6 pour contrôler le gaz d'électrons bidimensionnel. L'électrode de grille 10 est formée d'une région supérieure 12 qui est à base de métal et qui est en contact avec une région inférieure 11 semi-conductrice, par exemple à base de p-GaN.

Pour pouvoir prévenir le phénomène d'effondrement du courant (« current collapse ») on cherche à évaluer la valeur de résistance dynamique d'un tel transistor 105 GaN. Avantageusement, une telle évaluation peut être effectuée directement sur plaque (« wafer » selon la terminologie anglo-saxonne), autrement dit avant même que ce transistor ne soit séparé d'autres transistors avec lesquels il est formé de manière collective sur cette même plaque et que cette plaque ne soit divisée.

On peut, en variante, évaluer cette valeur de résistance dynamique après des étapes de division (« dicing » ou « wafer dicing » suivant la terminologie anglo-saxonne) et optionnellement après que le transistor soit mis en boîtier selon une étape d'encapsulation (« packaging » suivant la terminologie anglo-saxonne).

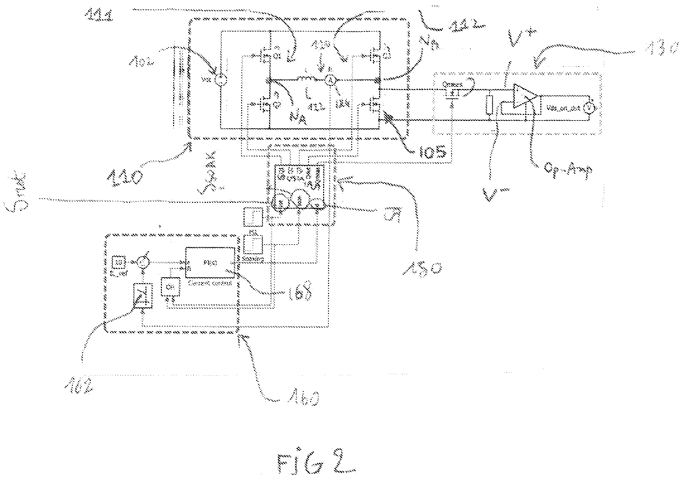

Pour permettre de mesurer la résistance dynamique drain source d'un transistor du type de celui décrit précédemment en lien avec la figure 1, on prévoit de l'intégrer à un circuit 110, tel qu'illustré sur la figure 2, de sorte à former un circuit de test à interrupteurs dont l'agencement s'apparente à celui d'un onduleur en pont.

Le circuit 110 est alimenté par le biais d'une alimentation 102 continue -DC/-DC par exemple de l'ordre de 10 volts jusqu'à 3 kV, en particulier entre 100 volts et 1700V.

Le circuit 110 est doté d'un premier bras 111 comprenant un premier élément interrupteur Q1, dans cet exemple un premier transistor, et un deuxième élément interrupteur Q2, ici un deuxième transistor, le deuxième élément interrupteur étant relié au premier élément interrupteur en un premier nœud N_{A}.

Le circuit 110 est également doté d'un deuxième bras 112 comprenant un troisième élément interrupteur Q3, ici un troisième transistor. Le transistor 105 GaN dont on souhaite évaluer la résistance dynamique drain R_{DS_ON_dyn} est destiné à compléter le deuxième bras et former le quatrième élément interrupteur du circuit de test. Le troisième transistor Q3 et le transistor 105 GaN sont ici reliés en un deuxième nœud NB.

Avantageusement, le transistor 105 GaN n'est placé que de manière provisoire en connexion avec les autre éléments interrupteurs Q1, Q2, Q3 pour former le circuit 110. Dans ce cas, une fois que la ou les mesures de résistance dynamique drain-source à l'état passant R_{DS_ON_dyn} ont été effectuées, on peut remplacer le transistor 105 par un autre transistor du même type dont on souhaite également évaluer la résistance dynamique drain-source à l'état passant R_{DS_ON_dyn}.

Les transistors formant ici respectivement le premier, deuxième et troisième élément interrupteur Q1, Q2, Q3, sont typiquement réalisés dans une technologie distincte de celle du transistor 105 GaN. Ainsi, ces transistors peuvent être en particulier des transistors MOS, avantageusement des MOS de puissance dont la région de canal est par exemple formée dans une couche de silicium. Dans l'exemple de réalisation particulier illustré des transistors NMOS à enrichissement sont utilisés.

On prévoit de mesurer un courant I_{L} dans une branche 120 de circuit entre le premier nœud N_{A} et ce deuxième nœud N_{B} afin d'obtenir une image du courant drain-source IDS_ON du transistor 105 GaN lorsque ce dernier est passant.

Pour évaluer le courant I_{L}, une branche 120 de circuit entre le premier nœud N_{A} et le deuxième nœud NB comprend un capteur 124 de courant. Un capteur de type à « effet hall » comme par exemple un capteur commercialisé par la société LEM, en particulier de type LEM CKSR, 50A peut permettre de mesurer le courant traversant une charge inductive 122 d'inductance L. Cette charge inductive 122 est de préférence prévue avec une très faible capacité parasite parallèle en haute fréquence par exemple de l'ordre de 0.3 pF dans une plage de fréquence entre 10 MHz et 60 MHz. Le courant I_{L} est l'image du courant traversant le transistor 105 en GaN lorsque ce dernier est mis à l'état passant et que la branche 120 est mise en série avec ce transistor 105.

Un étage de mesure 130 de la tension drain source du transistor GaN 105 lorsque ce dernier est mis à l'état passant est également prévu et couplé à l'électrode de drain D et à l'électrode de source S du transistor 105 en GaN.

L'étage 130 de mesure de la tension drain source, est ici doté d'un amplificateur opérationnel Op-Amp selon un montage suiveur, avec une sortie rebouclant sur son entrée inverseuse.

L'amplificateur opérationnel Op-Amp produit en sortie une tension Vds_ON_dut proportionnelle à une différence de potentiels entre un potentiel d'électrode de drain D du transistor 105 mis à l'état passant et un potentiel d'électrode de source S du premier transistor 105 mis à l'état passant.

Dans l'exemple illustré, le drain D du transistor 105 est apte à être couplé lors d'une phase de mesure à l'entrée non-inverseuse V+ de l'amplificateur opérationnel Op-Amp.

Un interrupteur Qₘₑₐₛ dit « de mesure » est agencé entre l'électrode de drain D du transistor 101 et l'entrée non-inverseuse V+ de l'amplificateur opérationnel Op-Amp. Cet interrupteur Qₘₑₐₛ de mesure est formé dans cet exemple d'un transistor de couplage ici de type N, en particulier un NMOS à enrichissement, dont la grille est commandée par un signal SQmeas de commande de mesure, pour activer le transistor M₁ de couplage et déclencher une phase de mesure.

Lorsque l'interrupteur Qₘₑₐₛ est mis à l'état passant, l'électrode de drain D du transistor 105 est connectée à l'amplificateur consécutivement.

On effectue ici la mesure de tension de drain source pendant la mise en conduction du transistor 105 en GaN. Lorsque la phase de mesure est terminée, le signal de commande de mesure SQmeas est modifié de sorte à déconnecter l'électrode de drain D du transistor 105 de l'amplificateur Op-Amp.

L'amplificateur opérationnel Op-Amp est avantageusement prévu avec une vitesse de balayage (« Slew Rate » selon la terminologie anglo-saxonne) élevée, c'est-à-dire typiquement d'au moins plusieurs centaines de volts par µs, par exemple de l'ordre de 400 V/µs. Avantageusement, l'amplificateur opérationnel Op-Amp peut être alimenté entre V+ et V- par le biais d'une batterie externe, ce qui permet de minimiser les perturbations dans les mesures.

Les éléments interrupteurs Q1, Q2, Q3, et le transistor 105 dont on souhaite mesurer la résistance drain source dynamique R_{DS_ONdyn}, et en particulier leurs états respectifs actif ou inactif (i.e. respectivement passant ou bloqué) sont contrôlés respectivement par des signaux de commande SQ1, SQ2, SQ3, SQ_{OUT}.

Un étage 150 de commande connecté au circuit de test 110 peut être prévu pour produire ces signaux de commande SQ1, SQ2, SQ3, SQ_{OUT}, respectivement des éléments interrupteurs Q1, Q2, Q3 et du transistor 105, ici appliqués sur leurs électrodes de grilles respectives, ainsi que du signal SQmeas de commande de mesure. Ces signaux sont typiquement produits sous forme d'impulsions et selon des séquences correspondant aux différentes phases de fonctionnement du dispositif, en particulier pour mettre en œuvre une phase dite « de trempage » et une phase dite « de régulation de courant et de mesure » également appelée « phase de mesure ». L'étage de commande 150 est typiquement un circuit numérique ou doté d'un bloc numérique ou est intégré à un circuit numérique, par exemple de type microcontrôleur ou un circuit logique programmable.

Dans l'exemple de fonctionnement illustré, l'étage 150 de commande reçoit lui-même des signaux Srst, Ssoak et Sd.

Le signal Srst est un signal de réinitialisation de l'étage de commande 150 pour le remettre dans une phase dite « d'arrêt ». Les signaux de commande respectifs SQ1, SQ2, SQ3, SQ_{OUT}, SQmeas sont mis lors de cette phase d'arrêt dans un état inactif, ici un état bas, de sorte que les interrupteurs Q1, Q2, Q3, Q_{OUT}, Qₘₑₐₛ sont désactivés (i.e. à l'état bloqué).

Le signal Ssoak est un signal de déclenchement de fin de la phase dite « de trempage », qui est préalable à la phase de mesure, et dont la durée peut être réglée et modulée d'une mesure à l'autre de résistance dynamique.

La durée du trempage peut dépendre en particulier de l'application visée pour le transistor sous test. On peut également réaliser différents tests avec des durées distinctes de trempage d'un test à l'autre afin de déterminer les caractéristiques du transistor. Par exemple, un servo-contrôleur de type « dSpace » produit par la Société dSpace GmbH ou un circuit logique programmable de type FPGA peut être utilisé pour moduler cette durée.

Le signal Sd peut être indicateur d'un rapport cyclique. L'étage 150 de commande est susceptible de modifier les états respectifs de certains de ses signaux de commande SQ1, SQ2, SQ3, SQ_{OUT}, SQmeas consécutivement à la réception d'un tel signal.

Ce signal Sd peut être lui-même produit par un étage 160 de régulation. Un tel étage 160 reçoit une mesure du courant I_{L} mesuré par le capteur de courant 124, peut récupérer une valeur moyenne de ce courant par le biais d'un bloc 162, qui produit une moyenne de courant mesuré afin de pouvoir comparer cette valeur moyenne avec une valeur de courant de référence IL_ref servant de valeur de consigne. Le résultat de cette comparaison est transmis à un étage correcteur 168, ici de type PI («proportionnel-intégral ») qui produit le signal Sd. La régulation peut être réinitialisée par le biais de la réception du signal de réinitialisation Srst de l'étage de commande 150 ou du signal Ssoak de déclenchement de fin de phase de trempage.

L'étage de commande 150 peut être configuré pour déclencher un passage de la première configuration vers la deuxième configuration selon la méthode suivante :
- Le courant mesuré dans l'inductance I_{L} peut être moyenné et comparé à une consigne de courant IL_ref prédéterminée, le résultat de cette comparaison est utilisée par l'étage de régulation 160 dotée d'un étage correcteur 168, en particulier un correcteur de type PI, configuré pour calculer un rapport cyclique à partir de cette différence de courant.
- Ce rapport cyclique, compris entre zéro et un, est représentatif d'une proportion entre la durée de la première configuration et la durée totale des deux configurations successives, cette durée totale étant de préférence fixe et prédéterminée ;
- La valeur du rapport cyclique calculé est transmise sous forme du signal Sd et utilisée par un circuit de type « modulation de largeur d'impulsion » (MLI) appartenant à l'étage de commande 150 et qui pilote les quatre transistors Q1, Q2, Q3, 105 successivement selon la première configuration puis la deuxième configuration et à nouveau selon la première configuration suivie de la deuxième configuration et ainsi de suite jusqu'à l'arrêt du test. Un tel arrêt peut être déclenché lorsqu'un critère de convergence est atteint ou une durée de mesure prédéterminée est atteinte.

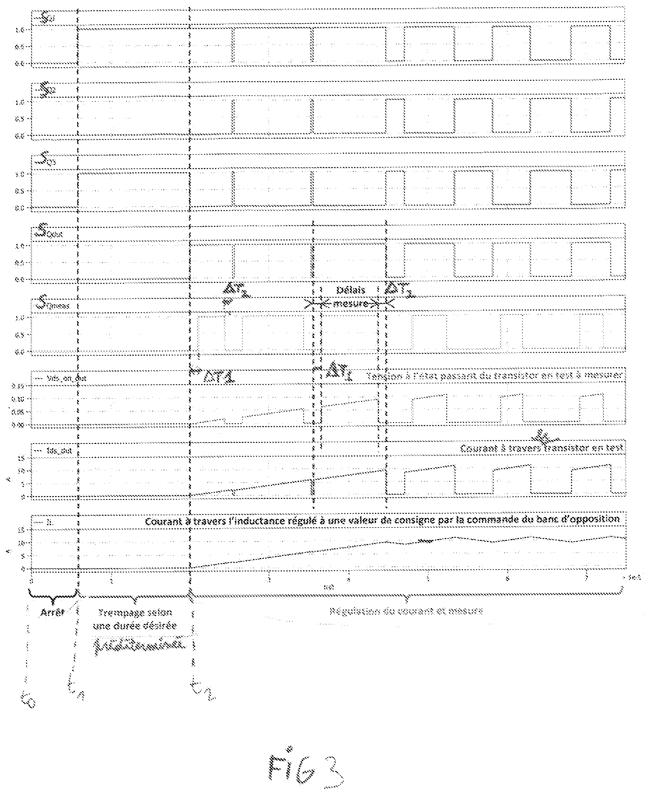

Un exemple de fonctionnement du dispositif de test avec les différentes phases de fonctionnement précitées est illustré sur le chronogramme de la figure 3, donnant une évolution possible des signaux de commande respectifs SQ1, SQ2, SQ3, des éléments interrupteurs Q1, Q2, Q3, du signal de commande SQ_{OUT} du transistor 105 sous test, du signal SQmeas de déclenchement de phase de mesure, de la tension V_{DS_on_DUT}, du transistor 105 à base de GaN, du courant I_{DS_DUT} du transistor 105 à base de GaN, et du courant I_{L} traversant la charge inductive 122 et circulant dans la branche 120.

Préalablement à la phase de fonctionnement dite « de trempage » (entre un instant t₀ et un instant t₁), le dispositif est dans la phase d'arrêt et les signaux SQ1, SQ2, SQ3, SQ_{OUT}, SQmeas sont ici à un état bas correspondant à un état désactivé ou bloqué des transistors qu'ils commandent respectivement.

Puis, préalablement à une phase de mesure, la phase de trempage de durée déterminée et réglable est mise en œuvre.

La durée de cette phase peut être prévue par exemple entre une microseconde à plusieurs secondes et est fixée à une durée prédéterminée. Cette durée prédéterminée peut être sélectionnée parmi différentes durées par exemple de 1 µs, 2 µs, 2s et 10s en fonction des caractéristiques du transistor 105 sous test. La durée de trempage peut être ajustée d'une mesure à l'autre effectuée sur le même transistor 105 ou sur un transistor suivant venant remplacer le transistor 105 dans le deuxième bras du circuit 110 de test.

Lors de cette phase de trempage déclenchée ici à un instant t₁, les signaux de commande SQ₁ et SQ₃ du premier élément interrupteur Q1 et du troisième élément interrupteur Q3 sont mis dans un premier état, ici un état haut, de sorte à rendre passants le premier interrupteur Q1 et le troisième interrupteur Q3, tandis que le deuxième interrupteur Q2 et le transistor 105 à base de GaN sont maintenus bloqués par l'intermédiaire des signaux de commande SQ₁ et SQ_{dut} maintenus dans un deuxième état ici un état bas ou désactivé. Ainsi, ledit transistor 105 à base de GaN est couplé à l'alimentation 102 tandis que les nœuds N_{A} et N_{B} sont mis au même potentiel et en particulier à la tension d'alimentation. Durant cette phase de trempage on impose ainsi la tension d'alimentation entre le drain et la source du transistor 105.

On contrôle ici avantageusement le trempage et sa durée sans devoir ajouter de bras supplémentaire au circuit 110 de test et sans complexifier l'agencement de ce circuit de test.

La phase de trempage se termine à un instant t₂ pour démarrer ensuite la phase de régulation de courant et de mesure.

Le signal SQ_{OUT} de commande du transistor 105 sous test est alors modifié par l'étage de commande 150 et en particulier mis dans un état, ici un état haut, de sorte à rendre passant, autrement dit à activer le transistor 105 GaN. Les signaux SQ2, SQ3 du deuxième élément interrupteur Q2 et du troisième élément interrupteur Q3 sont quant à eux maintenus dans un état bas de sorte à maintenir désactivé (i.e. bloqué) le deuxième interrupteur Q2 et le troisième élément interrupteur Q3, tandis que le signal SQ₁, est maintenu dans un état haut de sorte à maintenir activé (i.e. passant) le premier élément interrupteur Q1. L'alimentation 102, la branche 120, et le transistor 105 sont alors mis en série. Le circuit de test 110 se trouve ainsi dans une première configuration correspondant à un premier ensemble d'état des éléments interrupteurs Q1, Q2, Q3, et du transistor 105.

Pour effectuer une mesure, le signal de commande SQmeas est modifié et activé avec un retard ΔT1 réglable après l'instant t₂ de démarrage de la première configuration afin de ne pas perturber le comportement en commutation du transistor 105. Le transistor Qₘₑₐₛ de l'étage 130 de mesure peut être ainsi amorcé ou rendu passant un délai ΔT1 par exemple d'une dizaine de nano-secondes après l'amorçage du transistor 105 GaN. L'étage de mesure 130 et en particulier l'amplificateur Op-Amp est alors connecté aux bornes du transistor 105 en GaN.

Puis, une fois la mesure de la tension drain source Vds_on_dut du transistor 105 effectuée, l'étage de mesure 130 et en particulier l'amplificateur Op-Amp est déconnecté du transistor 105 en GaN, en désactivant (i.e. bloquant) l'interrupteur Qₘₑₐₛ de mesure. Le transistor 105 est ensuite désamorcé (i.e. rendu bloqué) un délai ΔT2 réglable prédéterminé après la désactivation de l'interrupteur Qₘₑₐₛ. Les signaux SQ1, SQ2, SQ3, respectivement du premier élément interrupteur Q1, du deuxième élément interrupteur Q2 et du troisième élément interrupteur Q3 sont dans le même temps modifiés et respectivement mis dans des états de sorte à désactiver (i.e. bloquer) le premier interrupteur Q1, et activer (i.e. rendre passants) le deuxième élément interrupteur Q2 et le troisième élément interrupteur Q3.

On passe ainsi, de la première configuration à une deuxième configuration correspondant à un deuxième ensemble d'états des éléments interrupteur Q1, Q2, Q3, et du transistor 105. Dans cette deuxième configuration, l'alimentation 102 et la branche 120 forment un circuit fermé.

Les durées respectives de la première configuration et de la deuxième configuration dépendent de celle durant laquelle le signal SQmeas de déclenchement de mesure est activé, lui-même déduit du signal SQdut, lui-même formé à partir du signal Sd fourni par l'étage de régulation. Le signal SQmeas reproduit les variations du signal SQdut aux délais ΔT1 et ΔT2 près.

On amorce par le biais du signal SQmeas (autrement dit on met à l'état ON ou passant) l'interrupteur Qₘₑₐₛ plus tard que le transistor 105 sous test dont l'état est commandé par le signal SQdut et on ferme (autrement dit on met à l'état OFF) plus tôt l'interrupteur Qₘₑₐₛ que le transistor 105 pour éviter une perturbation de mesure liée à la commutation du transistor 105.

Lors de la phase de mesure, les signaux de commande SQ1, SQ2, SQ3, SQ_{OUT} alternent ainsi au moins une fois et typiquement plusieurs fois, entre un premier ensemble d'états et un deuxième ensemble d'états, de sorte que le circuit 110 de test alterne plusieurs fois entre la première configuration et la deuxième configuration.

Les éléments interrupteurs Q1, Q2, Q3 et 105 peuvent être ainsi commandés selon une méthode d'opposition du type de celle décrite par exemple dans le document « Use of Opposition method in the test of high-power electronic converters », de Forest et al., IEEE transaction on industrial electronics, 2006.

La durée totale de la phase de mesure peut être réglée selon une durée de test prédéterminée ou bien correspondre à un nombre de commutation prédéterminé entre la première configuration et la deuxième configuration.

La fin de la phase de mesure peut être également établie lorsqu'un critère de convergence est atteint. Un tel critère de convergence peut être par exemple tel que lorsqu'à l'issue de plusieurs échantillons de mesure de R_{DS_ONdyn}, la valeur mesurée de la résistance R_{DS_ONdyn} mesurée ne varie plus de K%, par exemple avec K=5, la fin de la phase de mesure est déclenchée.

La fin de la phase de mesure peut être également déclenchée par un utilisateur du dispositif de test, par exemple lorsqu'il visualise par le biais d'un instrument de mesure tel qu'un oscilloscope, qu'une convergence du courant d'inductance I_{L} autour de la valeur de consigne est atteinte.

La caractérisation du transistor 105 à base de GaN et en particulier les mesures de I_{LOAD} de V_{drop_DS_ON} afin d'évaluer la résistance R_{DS_ON_dyn} sont réalisés typiquement en chauffant le transistor 105 à une température qui peut être comprise par exemple entre 25°C et 175°C, dans la mesure où la température de fonctionnement du transistor 105 évalué se situe typiquement dans cette gamme.

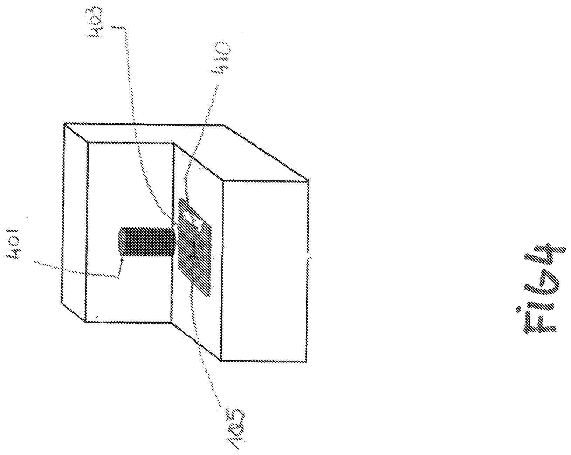

On met en œuvre de préférence un chauffage localisé du transistor 105 sans échauffer de manière significative les autres éléments du circuit de mesure, et notamment les éléments interrupteurs Q1, Q2, Q3. Pour cela, le chauffage peut être réalisé au moyen d'une source 401 de rayonnement infra-rouge émettant un faisceau infra-rouge 403 sur le transistor 105 GaN, comme dans l'exemple d'agencement illustré sur la figure 4. Le transistor 105 peut être disposé sur un support d'accueil 410, par exemple sous forme d'un plateau vers lequel le faisceau infrarouge est dirigé.

L'exposition au faisceau IR peut être intermittente et dépendante des mesures d'un capteur de température, le pilotage intermittent du faisceau pouvant être réalisé par exemple au moyen d'un régulateur PID (proportionnel, intégral, dérivé).

On peut prévoir au moins deux capteurs distincts de température, un premier qui mesure la température du transistor 105 et un autre capteur qui mesure l'environnement aux alentours. Une enveloppe isolante, telle qu'une couche à base de polyimide par exemple de type Kapton^{™} peut être utilisée pour protéger le circuit autour du transistor 105 lorsqu'il est soumis au rayonnement infrarouge.

Le faisceau infra-rouge peut être un faisceau actif, c'est-à-dire dont la puissance peut être modulée durant l'exposition. Un circuit de commande de type P.I.D (Proportionnel, Intégral, Dérivé) peut permettre de réguler la puissance de ce faisceau. Un exemple de profil de température du transistor 105 comporte une rampe de montée en température, puis un plateau de température constante, puis une rampe descendante.

Selon un mode de réalisation, le circuit de mesure décrit précédemment est intégré sur le support 410 d'accueil et c'est le transistor 105 GaN qui est rapporté et disposé de manière amovible sur ce support 410 tout en étant connecté au circuit de mesure. En variante il est possible de prévoir un support 410 d'accueil dédié au transistor 105, le reste du circuit de mesure étant connecté à ce support et au transistor 105, mais disposé sur un autre élément de support.

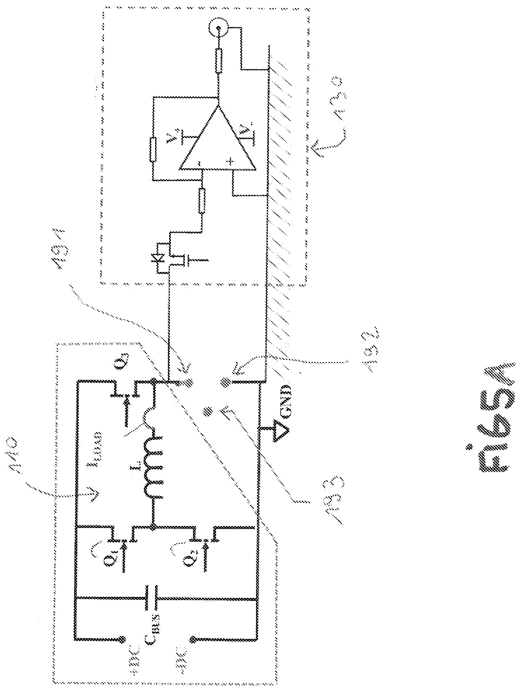

Ainsi, dans l'exemple de réalisation illustré sur la figure 5A, le circuit 110 est pourvu de zones 191, 192, 193 de connexion (représentées de manière schématique sur cette figure) respectivement de l'électrode de source, de l'électrode de drain et de l'électrode de grille du transistor GaN (non représenté). Les zones 191, 192, 193 de connexion peuvent être par exemple sous forme de plots conducteurs. Lorsque le transistor 105 est situé sur une plaque (wafer) comportant d'autres transistors du même type et qui peuvent être réparties sur d'autres puces électroniques sur laquelle le transistor 105 est situé, on connecte de manière provisoire ce transistor 105 aux zones 191, 192, 193 de connexion et on évalue la résistance R_{DS_ONdyn}. Une fois l'évaluation réalisée, on déconnecte le transistor 105 des zones de connexion 191, 192, 193 qui sont ainsi libérées et prêtes à être connectées à un autre transistor à tester et qui peut être sur la même plaque (wafer) que le transistor 105.

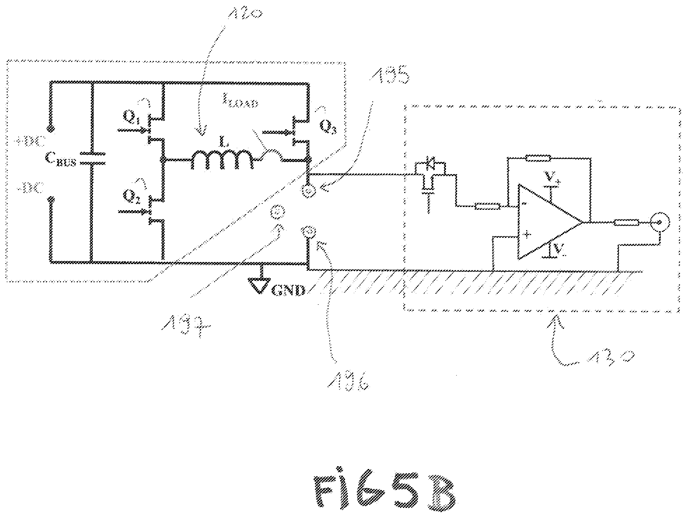

Selon une autre variante, le circuit 110 peut être pourvu de structures 195, 196, 197 d'accueil et de connexion (représentées de manière schématique sur la figure 5B) respectivement de l'électrode de source, de l'électrode de drain et de l'électrode de grille du transistor GaN (non représenté). Par exemple lorsque le transistor 105 est déjà encapsulé ou monté sur boîtier, on dispose le transistor 105, sur ces structures 195, 196, 197 d'accueil et de connexion et on évalue la résistance R_{DS_ON_dyn}. Une fois l'évaluation réalisée, on retire le transistor 105 du circuit 110 et les structures 195, 196, 197 sont ainsi libérées pour pouvoir accueillir un autre transistor à tester, par exemple un autre transistor monté sur boîtier.

Le transistor 105 à base de GaN testé peut être sous forme intégrée dans un boitier CMS (pour « composant monté en surface ») ou SMD (« surface mounted device »), ou bien d'un boitier traversant, c'est à dire muni de pattes de connexion, voire une puce nue (i.e. sans boitier).

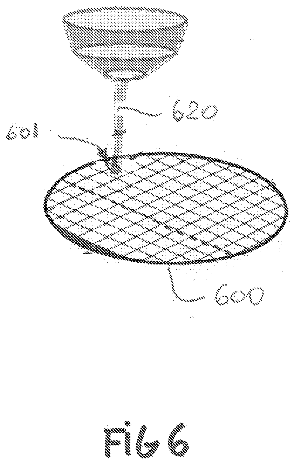

Dans l'exemple de réalisation illustré sur la figure 6, la mesure est effectuée directement sur plaque 600 (« wafer » selon la terminologie anglo-saxonne), avant même que cette plaque ne soit découpée, le circuit de test (non représenté) étant connecté au transistor GaN par le biais de pointes conductrices ou plots de contacts.

Pour mesurer une puce nue 601 sans boitier, on relie la puce 601 à des structures de connexion (non représentées) et on expose cette puce 601 à un faisceau infrarouge 620 de préférence projeté sur une face opposée à celle sur laquelle le transistor GaN à tester est disposé.

Selon un autre aspect, la présente demande vise à protéger un procédé d'évaluation de résistance dynamique à l'état passant d'un transistor GaN à l'aide d'un dispositif tel que défini plus haut, dans lequel la phase dite « de mesure » est arrêtée lorsqu'un critère de convergence du courant (IL) traversant la charge inductive est atteint ou lorsqu'une durée de mesure prédéterminée est atteinte.

## Revendications

1. Dispositif d'évaluation de la résistance dynamique à l'état passant d'un transistor (105) à base de GaN, comprenant un circuit (110) de test ayant :
- un premier bras (111) de circuit, ledit premier bras étant doté d'un premier élément interrupteur (Q1) et d'un deuxième élément interrupteur (Q2) connectés entre eux à un premier nœud (N_{A}), ledit circuit de test étant doté d'un troisième élément interrupteur (Q3) connecté à deuxième nœud (N_{B}), ledit troisième élément interrupteur (Q3) étant apte à former un deuxième bras (112) dudit circuit de test avec ledit transistor (105) à base de GaN lorsque ledit transistor (105) à base de GaN est connecté au deuxième nœud (NB),
- une alimentation (102) délivrant une tension d'alimentation (DC+,DC-) au premier bras et au deuxième bras,
- une branche (120) entre le premier nœud (N_{A}) et le deuxième nœud (N_{B}) munie d'une charge (110) inductive et d'un capteur de courant (124), pour mesurer un courant (IL) traversant cette charge inductive, le dispositif étant **caractérisé par**
- un interrupteur de mesure (Qₘₑₐₛ) pour alternativement connecter ledit transistor à base de GaN à un étage de mesure de tension drain-source à l'état passant dudit transistor (105) base de GaN, et déconnecter ledit transistor à base de GaN dudit étage de mesure de tension drain-source lorsque ledit interrupteur de mesure (Qₘₑₐₛ) est mis à l'état bloqué,
- un étage (150) de commande desdits premier, deuxième et troisième éléments interrupteurs (Q1, Q2, Q3), dudit transistor (105) à base de GaN et de l'interrupteur de mesure (Qₘₑₐₛ)
- selon une phase dite « de mesure », mettre, une ou plusieurs fois alternativement le circuit (110) de test dans une première configuration, puis dans une deuxième configuration, la première configuration étant une configuration dans laquelle le premier élément interrupteur (Q1) et ledit transistor (105) à base de GaN sont rendus passants tandis que le deuxième élément interrupteur (Q2) et le troisième élément interrupteur (Q3) sont rendus bloqués, de sorte à mettre en série ladite alimentation (102), ladite branche (120), et le ledit transistor (105) à base de GaN, la deuxième configuration étant une configuration durant laquelle le deuxième élément interrupteur (Q2) et le troisième élément interrupteur (Q3) sont à l'état passant tandis que le premier élément interrupteur (Q1) et ledit transistor (105) à base de GaN sont mis à l'état bloqué de sorte à mettre en circuit fermé ladite branche (120) avec ladite alimentation (102),
l'étage de commande (150) étant configuré pour déclencher une connexion de l'étage (120) de mesure de tension drain-source audit transistor (105) base de GaN après que le circuit de test soit mis dans la première configuration, et pour déclencher une déconnexion de l'étage (120) de mesure de tension drain-source dudit transistor (105) base de GaN préalablement à ce que le circuit de test soit mis dans la deuxième configuration.

2. Dispositif selon la revendication 1, dans lequel l'étage (150) de commande est en outre configuré pour, préalablement à la phase de mesure, mettre en œuvre une phase de trempage d'une durée prédéterminée réglable, en rendant passants le premier interrupteur (Q1) et le troisième interrupteur (Q3) tandis que le deuxième interrupteur (Q2) et le transistor (105) à base de GaN sont maintenus bloqués de sorte à mettre le premier nœud (NA) et le deuxième nœud (NB) à ladite tension d'alimentation.

3. Dispositif selon l'une des revendications 1 ou 2, l'étage de commande (150) étant configuré pour déclencher une connexion de l'étage (120) de mesure de tension drain-source audit transistor (105) base de GaN un premier délai réglable prédéterminé (ΔT1) non-nul après que le circuit à interrupteurs soit mis dans la première configuration, et pour déclencher une déconnexion de l'étage (120) de mesure de tension drain-source dudit transistor (105) base de GaN, un deuxième délai réglable prédéterminé non-nul avant que le circuit à interrupteurs soit mis dans la deuxième configuration.

4. Dispositif selon l'une des revendications 1 à 3, l'étage (120) de mesure de la tension drain source comprend un amplificateur opérationnel (OP-AMP) monté en suiveur et dont l'entrée non-inverseuse (V+) est apte à être connectée à l'électrode de drain (D1) du premier transistor (11).

5. Dispositif selon l'une des revendications 1 à 4, dans lequel l'étage de commande (150) est configuré pour déclencher un passage de la première configuration vers la deuxième configuration ou de la deuxième configuration vers la première configuration en fonction des variations d'un signal (Sd) en provenance d'un circuit de régulation (160) du courant (IL) de ladite charge inductive, ce signal (Sd) résultant lui-même d'une comparaison entre ledit courant (I_{L}) traversant la charge inductive et une valeur de consigne.

6. Dispositif selon la revendication 5, dans lequel circuit de régulation (160) est configuré pour établir la différence entre une valeur moyennée du courant (I_{L}) traversant la charge inductive et ladite consigne, et comporte un étage (168) correcteur, en particulier de type proportionnel intégral (PI), configuré pour calculer un rapport cyclique à partir de cette différence, ce rapport cyclique, compris entre zéro et un, étant représentatif d'une proportion entre la durée de ladite première configuration et la durée totale de la première configuration et de la deuxième configuration successives, la valeur du rapport cyclique étant transmise par le biais dudit signal (Sd) en provenance d'un circuit de régulation (160) à un circuit de modulation par largeur d'impulsion de l'étage de commande (150) pour piloter la grille du premier élément interrupteur (Q1), du deuxième élément interrupteur (Q2), du troisième élément interrupteur (Q1, Q2, Q3), et dudit transistor (105) à base de GaN.

7. Dispositif selon l'une des revendications 1 à 6, comprenant en outre un moyen de chauffage du transistor à base de GaN, le moyen de chauffage étant en particulier doté d'une source (401) de rayonnement infrarouge configurée pour émettre un faisceau (403) lumineux infrarouge localisé sur le transistor (105) à base de GaN.

8. Dispositif selon l'une des revendications précédentes, dans lequel ledit circuit est agencé sur un support doté de zones (191, 192, 193) ou structures (195, 196, 197) de connexion sur lesquelles, respectivement une électrode de source, une électrode de drain, et une électrode de grille du transistor (105) GaN sont aptes à être connectées de manière amovible.

9. Dispositif selon la revendication 8, dans lequel le transistor (105) à base de GaN est encapsulé et/ou monté sur boitier et dans lequel ledit circuit (110) est agencé sur un support (410), les structures (195, 196, 197) de connexion étant des structures de connexion et d'accueil prévues respectivement pour permettre un assemblage solidaire du transistor sur ledit support.

10. Dispositif selon la revendication 9, dans lequel le transistor (105) est agencé sur une plaque comportant une pluralité de puces électronique, chaque puce électronique étant dotée d'au moins un autre transistor GaN, le transistor (105) GaN étant connecté audit support du circuit à interrupteurs (110).

11. Procédé microélectronique comprenant au moins une étape d'évaluation de résistance dynamique à l'état passant d'un transistor GaN et s'appuyant sur un dispositif d'évaluation selon la revendication 10, le procédé comprenant des étapes consistant à :
- connecter le transistor aux zones (191, 192, 193) de connexion afin d'évaluer sa résistance dynamique drain source à l'état passant, puis
- déconnecter, le transistor desdites zones (191, 192, 193) de connexion, puis,
- découper le support afin de séparer lesdites puces électroniques.

12. Procédé d'évaluation de résistance dynamique à l'état passant d'un transistor GaN à l'aide d'un dispositif selon l'une des revendications 1 à 10 dans lequel la phase dite « de mesure » est arrêtée lorsqu'un critère de convergence traversant la charge inductive est atteint ou une durée de mesure prédéterminée est atteinte.

## Patentansprüche

1. Vorrichtung zur Bewertung des dynamischen Durchgangswiderstands eines GaN-basierten Transistors (105), umfassend eine Testschaltung (110), die Folgendes aufweist:
- einen ersten Schaltarm (111), wobei der erste Arm mit einem ersten Schaltelement (Q1) und einem zweiten Schaltelement (Q2) ausgestattet ist, die an einem ersten Knotenpunkt (NA) miteinander verbunden sind, wobei die Testschaltung mit einem dritten Schaltelement (Q3) ausgestattet ist, das mit einem zweiten Knotenpunkt (NB) verbunden ist, wobei das dritte Schaltelement (Q3) dazu ausgelegt ist, einen zweiten Arm (112) der Testschaltung mit dem GaN-basierten Transistor (105) zu bilden, wenn der GaN-basierte Transistor (105) mit dem zweiten Knoten (NB) verbunden ist,
- eine Stromversorgung (102), die eine Versorgungsspannung (DC+,DC-) an den ersten Arm und den zweiten Arm liefert,
- einen Zweig (120) zwischen dem ersten Knoten (N_{A}) und dem zweiten Knoten (N_{B}) mit einer induktiven Last (110) und einem Stromsensor (124), um einen durch diese induktive Last fließenden Strom (IL) zu messen, wobei die Vorrichtung **gekennzeichnet ist durch**
- einen Messschalter (Qₘₑₐₛ) zum alternativen Verbinden des GaN-basierten Transistors mit einer Drain-Quell-Spannungsmessstufe in dem Durchgangszustand des GaN-basierten Transistors (105) und Trennen des GaN-basierten Transistors von der Drain-Quell-Spannungsmessstufe, wenn der Messschalter (Qₘₑₐₛ) in den gesperrten Zustand versetzt wird,
- eine Steuerstufe (150) der ersten, zweiten und dritten Schaltelemente (Q1, Q2, Q3), des GaN-basierten Transistors (105) und des Messschalters (Qₘₑₐₛ), wobei die Steuerstufe für Folgendes konfiguriert ist:
- nach einer "Messphase", Schalten der Testschaltung (110) ein- oder mehrmals abwechselnd in eine erste Konfiguration und dann in eine zweite Konfiguration, wobei die erste Konfiguration eine Konfiguration ist, in der das erste Schaltelement (Q1) und der GaN-basierte Transistor (105) durchgeschaltet werden, während das zweite Schaltelement (Q2) und das dritte Schaltelement (Q3) gesperrt werden, so dass die Stromversorgung (102), der Zweig (120) und der GaN-basierte Transistor (105) in Serie geschaltet werden, wobei die zweite Konfiguration eine Konfiguration ist, in der sich das zweite Schaltelement (Q2) und das dritte Schaltelement (Q3) in dem Durchgangszustand befinden, während das erste Schaltelement (Q1) und der GaN-basierte Transistor (105) in den gesperrten Zustand versetzt werden, um den Zweig (120) mit der Stromversorgung (102) geschlossen zu schalten,
wobei die Steuerstufe (150) so konfiguriert ist, dass sie eine Verbindung der Drain-Quell-Spannungsmessstufe (120) mit dem GaN-basierten Transistor (105) auslöst, nachdem die Testschaltung in die erste Konfiguration gesetzt wurde, und dass sie eine Trennung der Drain-Quell-Spannungsmessstufe (120) des GaN-basierten Transistors (105) auslöst, bevor die Testschaltung in die zweite Konfiguration gesetzt wird.

2. Vorrichtung nach Anspruch 1, wobei die Steuerstufe (150) ferner so konfiguriert ist, dass sie vor der Messphase eine Einweichphase mit einer vorbestimmten einstellbaren Dauer durchführt, indem der erste Schalter (Q1) und der dritte Schalter (Q3) durchgeschaltet werden, während der zweite Schalter (Q2) und der GaN-basierte Transistor (105) so gesperrt gehalten werden, dass der erste Knoten (NA) und der zweite Knoten (NB) an die Versorgungsspannung angeschlossen werden.

3. Vorrichtung nach einem der Ansprüche 1 oder 2, wobei die Steuerstufe (150) so konfiguriert ist, dass sie eine Verbindung der Drain-Quell-Spannungsmessstufe (120) mit dem GaN-Basistransistor (105) nach einer vorbestimmten einstellbaren Verzögerung (ΔT1) ungleich null auslöst, nachdem der Schaltkreis in die erste Konfiguration gebracht wurde, und eine Trennung der Drain-Quell-Spannungsmessstufe (120) des GaN-Basistransistors (105) nach einer zweiten voreingestellten einstellbaren Verzögerung ungleich null auslöst, bevor der Schaltkreis in die zweite Konfiguration versetzt wird.

4. Vorrichtung nach einem der Ansprüche 1 bis 3, wobei die Drain-Quell-Spannungsmessstufe (120) einen als Folger montierten Betriebsverstärker (OP-AMP) umfasst, dessen nicht invertierter Eingang (V+) dazu ausgelegt ist, mit der Drain-Elektrode (D1) des ersten Transistors (11) verbunden zu werden.

5. Vorrichtung nach einem der Ansprüche 1 bis 4, wobei die Steuerstufe (150) so konfiguriert ist, dass sie einen Übergang von der ersten Konfiguration zur zweiten Konfiguration oder von der zweiten Konfiguration zur ersten Konfiguration in Abhängigkeit von den Schwankungen eines Signals (Sd) ausgehend von einer Regelschaltung (160) des Stroms (IL) der induktiven Last auslöst, wobei dieses Signal (Sd) selbst aus einem Vergleich zwischen dem durch die induktive Last fließenden Strom (IL) und einem Sollwert resultiert.

6. Vorrichtung nach Anspruch 5, wobei die Regelschaltung (160) so konfiguriert ist, dass sie die Differenz zwischen einem durchschnittlichen Wert des durch die induktive Last fließenden Stroms (I_{L}) und dem Sollwert feststellt, und eine Korrekturstufe (168) aufweist, insbesondere vom integralen Proportionaltyp (Pl), die so konfiguriert ist, dass sie aus dieser Differenz ein Tastverhältnis berechnet, wobei dieses Tastverhältnis, das zwischen null und eins liegt, repräsentativ für ein Verhältnis zwischen der Dauer der ersten Konfiguration und der Gesamtdauer der ersten aufeinanderfolgenden Konfiguration und der zweiten Konfiguration ist, wobei der Wert des Tastverhältnisses über das von einer Regelschaltung (160) kommende Signal (Sd) an eine Pulsbreitenmodulationsschaltung der Steuerstufe (150) übertragen wird, um das Gitter des ersten Schaltelements (Q1), des zweiten Schaltelements (Q2), des dritten Schaltelements (Q1, Q2, Q3) und des GaN-basierten Transistors (105) zu steuern.

7. Vorrichtung nach einem der Ansprüche 1 bis 6, ferner umfassend ein Heizmittel des GaN-basierten Transistors, wobei das Heizmittel insbesondere mit einer Infrarotstrahlungsquelle (401) ausgestattet ist, die so konfiguriert ist, dass sie einen auf dem GaN-basierten Transistor (105) lokalisierten Infrarotlichtstrahl (403) aussendet.

8. Vorrichtung nach einem der vorhergehenden Ansprüche, wobei die Schaltung auf einem Träger angeordnet ist, der mit Bereichen (191, 192, 193) oder Verbindungstrukturen (195, 196, 197) ausgestattet ist, an denen jeweils eine Quellelektrode, eine Drain-Elektrode und eine Gitterelektrode des Transistors (105) GaN beweglich verbunden werden können.

9. Vorrichtung nach Anspruch 8, wobei der Transistor (105) auf GaN-Basis gekapselt und/oder auf einem Gehäuse montiert ist und wobei die Schaltung (110) auf einem Träger (410) angeordnet ist, wobei die Verbindungsstrukturen (195, 196, 197) jeweils Verbindungs- und Aufnahmestrukturen sind, die vorgesehen sind, um eine feste Montage des Transistors auf dem Träger zu ermöglichen.

10. Vorrichtung nach Anspruch 9, wobei der Transistor (105) auf einer Platte angeordnet ist, die eine Vielzahl von elektronischen Chips aufweist, wobei jeder elektronische Chip mit mindestens einem anderen GaN-Transistor ausgestattet ist, wobei der Transistor (105) GaN mit dem Träger des Schaltkreises (110) verbunden ist.

11. Mikroelektronisches Verfahren, das mindestens einen Schritt zur Bewertung des dynamischen Durchgangswiderstands eines GaN-Transistors umfasst und sich auf eine Bewertungsvorrichtung nach Anspruch 10 stützt, wobei das Verfahren Schritte umfasst, die in Folgendem bestehen:
- Verbinden des Transistors mit den Verbindungsbereichen (191, 192, 193), um seinen dynamischen Drain-Quell-Widerstand in dem Durchgangszustand zu bewerten, dann
- Trennen des Transistors von den Verbindungsbereichen (191, 192, 193) und dann
- Zuschneiden des Trägers, um die elektronischen Chips zu trennen.

12. Verfahren zur Bewertung des dynamischen Durchgangswiderstands eines GaN-Transistors mithilfe einer Vorrichtung nach einem der Ansprüche 1 bis 10, wobei die "Messphase" gestoppt wird, wenn ein Kriterium für die Konvergenz durch die induktive Last erreicht ist oder eine vorbestimmte Messdauer erreicht ist.

## Claims

1. A device for assessing the dynamic resistance in the conducting state of a GaN-based transistor (105), comprising a test circuit (110) having:
- a first circuit arm (111), said first arm being provided with a first switch element (Q1) and with a second switch element (Q2) connected together at a first node (N_{A}), said test circuit being provided with a third switch element (Q3) connected to the second node (N_{B}),said third switch element (Q3) being able to form a second arm (112) of said test circuit with said GaN-based transistor (105) when said GaN-based transistor (105) is connected to the second node (NB),
- a power supply (102) delivering a supply voltage (DC+, DC-) to the first arm and to the second arm,
- a branch (120) between the first node (N_{A}) and the second node (N_{B}) provided with an inductive load (110) and with a current sensor (124), to measure a current (IL) flowing through this inductive load, the device being **characterised by**
- a measuring switch (Qₘₑₐₛ) for alternately connect said GaN-based transistor to a drain-source voltage measuring stage in the conducting state of said GaN-based transistor (105), and disconnect said GaN-based transistor from said drain-source voltage measuring stage when said measuring switch (Qₘₑₐₛ) is set in the non-conducting state,
- a control stage (150) of said first, second and third switch elements (Q1, Q2, Q3), of said GaN-based transistor (105) and of the measuring switch (Qₘₑₐₛ), the control stage being configured to:
- according to a so-called "measurement" phase, alternately set, once or several times, the test circuit (110) in a first configuration, then in a second configuration, the first configuration being a configuration in which the first switch element (Q1) and said GaN-based transistor (105) are made conducting whereas the second switch element (Q2) and the third switch element (Q3) are made non-conducting, so as to set said power supply (102) in series, said branch (120), and said GaN-based transistor (105), the second configuration being a configuration during which the second switch element (Q2) and the third switch element (Q3) are in the conducting state whereas the first switch element (Q1) and said GaN-based transistor (105) are set in the non-conducting state so as to set said branch (120) in closed circuit with said power supply (102),
the control stage (150) being configured to trigger a connection of the drain-source voltage measuring stage (120) to said GaN-based transistor (105) after the test circuit is set in the first configuration, and to trigger a disconnection of the drain-source voltage measuring stage (120) of said GaN-based transistor (105) before the test circuit is set in the second configuration.

2. The device according to claim 1, wherein the control stage (150) is further configured, prior to the measurement phase, to implement a soaking phase lasting an adjustable predetermined duration, by making the first switch (Q1) and the third switch (Q3) conducting whereas the second switch (Q2) and the GaN-based transistor (105) are kept non-conducting so as to set the first node (NA) and the second node (NB) to said supply voltage.

3. The device according to one of claims 1 or 2, the control stage (150) being configured to trigger a connection of the drain-source voltage measuring stage (120) to said GaN-based transistor (105) a first non-zero predetermined adjustable delay (ΔT1) after the switch circuit is set in the first configuration, and to trigger a disconnection of the drain-source voltage measuring stage (120) from said GaN-based transistor (105), a second non-zero predetermined adjustable delay before the switch circuit is set in the second configuration.

4. The device according to one of claims 1 to 3, the drain-source voltage measuring stage (120) comprises an operational amplifier (OP-AMP) mounted as a follower and whose non-inverting input (V+) can be connected to the drain electrode (D1) of the first transistor (11).

5. The device according to one of claims 1 to 4, wherein the control stage (150) is configured to trigger a switch from the first configuration into the second configuration or from the second configuration into the first configuration according to the variation of a signal (Sd) originating from a circuit (160) for regulating the current (IL) of said inductive load, this signal (Sd) itself resulting from a comparison between said current (I_{L}) flowing through the inductive load and a setpoint value.

6. The device according to claim 5, wherein the regulation circuit (160) is configured to establish the difference between an averaged value of the current (I_{L}) flowing through the inductive load and said setpoint, and includes a corrector stage (168), in particular of the proportional integral (PI) type, configured to calculate a duty cycle from this difference, this duty cycle, comprised between zero and one, being representative of a proportion between the duration of said first configuration and the total duration of the successive first configuration and second configuration, the value of the duty cycle being transmitted via said signal (Sd) originating from a regulation circuit (160) to a pulse-width modulation circuit of the control stage (150) to control the gate of the first switch element (Q1), of the second switch element (Q2), of the third switch element (Q1, Q2, Q3), and of said GaN-based transistor (105).

7. The device according to one of claims 1 to 6, further comprising a means for heating the GaN-based transistor, the heating means being in particular provided with an infrared radiation source (401) configured to emit a localized infrared light beam (403) on the GaN-based transistor (105).

8. The device according to one of the preceding claims, wherein said circuit is arranged on a support provided with connection areas (191, 192, 193) or structures (195, 196, 197) on which a source electrode, a drain electrode and a gate electrode of the GaN transistor (105) can respectively be connected in a removable manner.

9. The device according to claim 8, wherein the GaN-based transistor (105) is embedded and/or mounted on a package and wherein said circuit (110) is arranged on a support (410), the connection structures (195, 196, 197) consisting of connection and receiving structures respectively configured to enable a secure assembly of the transistor on said support.

10. The device according to claim 9, wherein the transistor (105) is arranged on a wafer including a plurality of electronic chips, each electronic chip being provided with at least one GaN transistor, the GaN transistor (105) being connected to said support of the switch circuit (110).

11. A microelectronic method comprising at least one step of assessing the dynamic resistance in the conducting state of a GaN transistor and based on an assessment device according to claim 10, the method comprising steps of:
- connecting the transistor to connection areas (191, 192, 193) in order to assess its drain-source dynamic resistance in the conducting state, then
- disconnecting the transistor from said connection areas (191, 192, 193), then,
- cutting the support in order to separate said electronic chips.

12. A device for assessing the dynamic resistance in the conducting state of a GaN transistor using a device according to one of claims 1 to 10, wherein the so-called "measurement" phase is stopped when a criterion of convergence throughout the inductive load is met or a predetermined measurement duration is elapsed.
